# EUROPEAN PATENT APPLICATION

(11) **EP 3 578 682 A1**
(43) Date of publication of application: **11.12.2019**
(21) Application number: 18748656.8
(22) Date of filing: 30.01.2018
(51) Int. Cl.: C23C 14/08, C23C 14/22

(54) **FILM-FORMATION METHOD**

(30) Priority: 31.01.2017 JP 2017015266
(71) Applicant: Tokai University Educational System, Tokyo 151-0063 (JP); Shincron Co., Ltd., Kanagawa 220-8680 (JP)
(72) Inventor: MUROTANI, Hiroshi, Hiratsuka-shi Kanagawa 259-1292 (JP); HORIGUCHI, Yukio, Muroran-shi Hokkaido 051-8505 (JP); SUGAWARA, Takuya, Yokohama-shi Kanagawa 220-8680 (JP)
(74) Representative: Ter Meer Steinmeister & Partner
(86) International application number: PCT/JP2018/002995
(87) International publication number: WO 2018/143206

(57) **Abstract**

Provided is a film-formation method for a surface layer having high mechanical strength and a low refractive index. A step of film formation from a vapor deposition material by a vacuum vapor deposition method and a step of film formation by sputtering of a target constituent substance are repeated for the surfaces of substrates (S), thereby forming films with a lower refractive index than that of a film-forming material.

## Description

### [Technical Field]

The present invention relates to a film-formation method for a film having a low refractive index.

### [Background Art]

CCDs and CMOSs used as imaging elements are liable to cause flare and ghosting because the light reflection from the surface is stronger than that from silver salt photographic films. In addition, in lenses having a small radius of curvature, the incident angle of light rays greatly differs depending on the position, so the low reflectance cannot be maintained at a portion in which the inclination of the lens surface is large. Furthermore, in flat displays such as LCDs, anti-glare treatment is employed to overcome the issue of glaring of external light due to light reflection on the display surface, but as the display density becomes higher, the transmitting light through the liquid crystal leads to diffused reflection at the anti-glare-treated surface, which may hinder the high resolution of images. In order to reduce such reflection on the substrate surface, film formation of a surface layer having a low refractive index may be necessary (Non-Patent Document 1). On the other hand, for Al₂O₃, ZrO₂, Ta₂O₅, TiO₂, Nb₂O₅, HfO₂, or the like which is a film-forming material having a higher refractive index than that of glass, there are demands for freely selecting a desired refractive index and designing an optical thin film without being bound by the refractive indices of existing materials. It is therefore desired to form a thin film having a lower refractive index than those of such film-forming materials themselves.

### [Prior Art Document]

### [Patent Document]

[Non-Patent Document 1] New Technologies for Reduction of Light Reflection (KIKUTA Hisao, Journal of the Optical Society of Japan "KOGAKU (Optics)," Vol. 40, No. 1, January 2011)

### [Summary of Invention]

### [Problems to be solved by Invention]

It has been known to form a surface layer on a glass having a refractive index of 1.5 by using a low-refractive-index material such as magnesium fluoride having a refractive index of 1.38. However, even when such a material having a refractive index of 1.38 is used, reflection of 1.4% remains. At present, there are no thin film materials having such low refractive indices as 1.1 to 1.2. It has also been known to perform film formation of porous low-refractive-index films by a sol-gel method, but they may not be used as practical surface layers of substrates because they do not have sufficient mechanical strength to withstand cleaning such as ultrasonic cleaning or hand wiping.

A problem to be solved by the present invention is to provide a film-formation method for a film having a low refractive index.

### [Means for solving problems]

The present invention solves the above problem through repeating, for the surface of a substrate, a step of film formation from a vapor deposition material by a vacuum vapor deposition method and a step of film formation by sputtering of a target constituent substance, thereby forming a film with a lower refractive index than that of a film-forming material.

### [Effect of Invention]

According to the present invention, film formation of a film having a low refractive index can be performed.

### [Brief Description of Drawings]

FIG. 1 is a schematic longitudinal section illustrating an example of a film-formation apparatus used in an embodiment of the film-formation method according to the present invention.
FIG. 2 is a cross-sectional view along line II-II of FIG. 1.
FIG. 3 is a process flowchart illustrating an embodiment of the film-formation method according to the present invention.
FIG. 4 is a set of SEM photographs of thin films obtained in Example 1, Comparative Example 1, and Comparative Example 2.
FIG. 5 is an X-ray diffraction graph of the thin films obtained in Example 1, Comparative Example 1, and Comparative Example 2.
FIG. 6 is a graph illustrating the transmittance of the thin films obtained in Example 1, Comparative Example 1, and Comparative Example 2 and a substrate.

### [Mode(s) for Carrying out the Invention]

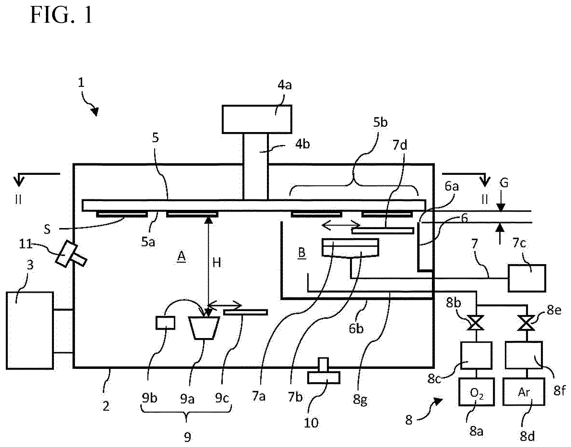

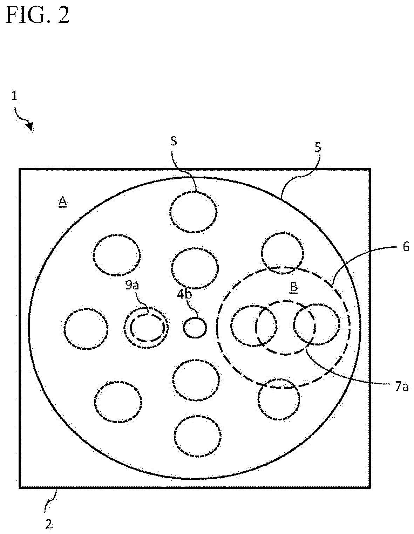

Hereinafter, an embodiment of the present invention will be described with reference to the drawings. FIG. 1 is a schematic longitudinal sectional view illustrating an example of a film-formation apparatus 1 that can be used in an embodiment of the film-formation method according to the present invention, and FIG. 2 is a cross-sectional view along line II-II of FIG. 1. It is to be noted that implementations of the film-formation method of the present invention are not limited in any way to the implementations using the film-formation apparatus 1 illustrated in FIGS. 1 and 2, and any type of film-formation apparatuses capable of realizing the features of the present invention can be employed. The film-formation apparatus 1 of this example comprises a vacuum chamber 2, an evacuation apparatus 3 for reducing the pressure inside the vacuum chamber 2, a substrate holder 5 capable of rotating around a rotation shaft 4b rotated by a driving unit 4a and capable of holding substrates S on a substrate-holding surface 5a, a differential pressure container 6 provided to face a sputtering part 5b that is a part of the substrate-holding surface 5a of the substrate holder 5, a sputtering mechanism 7 provided inside the differential pressure container 6, a gas instruction system 8 that introduces sputtering gases into the differential pressure container 6, and a vacuum vapor deposition mechanism 9 for vacuum vapor deposition that is provided to face the substrate-holding surface 5a inside the vacuum chamber 2.

As illustrated in FIGS. 1 and 2, the substrate holder 5 of this example is formed in a circular plate-like shape, and the rotation shaft 4b rotating in one direction by the driving unit 4a is fixed to the center of the circular plate. The lower surface of the substrate holder 5 serves as the substrate-holding surface 5a to which the substrates S are attached for being held by the substrate holder 5. FIG. 2 illustrates an example of the attachment form of the substrates S on the substrate holder 5, but the film-formation method of the present invention is not limited to using such an attachment form, and various forms can be employed.

In this example, to provide a gap G between the substrate-holding surface 5a of the substrate holder 5 and the upper end face 6a of the differential pressure container 6 so that a small amount of gases can pass through the gap G from a differential pressure region B inside the differential pressure container 6 to a high vacuum region A outside the differential pressure container 6 or vice versa, the substrate holder 5 is formed in a circular plate-like shape that allows the gap G to be readily adjusted to an appropriate clearance. Provided, however, that the gap G can be appropriately adjusted, the shape of the substrate holder 5 is not limited to the circular plate-like shape, and the substrate holder 5 may be formed in a dome-like shape or a cylindrical shape used for a carousel-type rotary film formation apparatus.

The substrates S which are objects of film formation are not particularly limited, and glass substrates as well as acrylic or other plastic substrates can be applied. Among these, substrates for optical use are required to have a reduced reflectance because of their large refractive indices and also required to have sufficient mechanical strength because of opportunities of contact with hands, washing, etc. When such substrates for optical use are used, therefore, the effect of the present invention is further effectively exerted.

The differential pressure container 6 is provided as a container body formed in a cylindrical shape. One end face 6b (lower face in FIG. 1) of the differential pressure container 6 in the axial direction is closed while the other end face 6a (upper face in FIG. 1) is opened. The differential pressure container 6 divides the interior of the vacuum chamber 2 into the high vacuum region A outside the differential pressure container 6 and the differential pressure region B inside the differential pressure container 6.

The open end face 6a of the differential pressure container 6 is formed in a circular shape, for example, and disposed with the predetermined gap G from the substrate-holding surface 5a of the substrate holder 5. This gap G is set to such a clearance that when the sputtering gases are introduced from the gas instruction system 8 into the differential pressure region B, the sputtering gases can leak through the gap G into the high vacuum region A thereby to adjust the pressure in the differential pressure region B to a predetermined pressure higher than that in the high vacuum region A. A preferred size of the gap G can be determined depending mainly on the volume of the differential pressure container 6, the flow rates of the sputtering gases, and the pressures in the high vacuum region A and differential pressure region B to be adjusted.

It suffices that the differential pressure container 6 has a shape facing a part of the substrate holder 5 and capable of being separated physically from the high vacuum region A, which is another space inside the vacuum chamber 2, by being provided with a communication part such as one or more holes or one or more gaps through which a small amount of gases can pass. Thus, the differential pressure container 6 is not limited only to being in a cylindrical shape as illustrated. For example, the inner wall of the vacuum chamber 2 may be provided with a shielding wall or the like thereby to form the differential pressure region B. In an alternative embodiment, instead of providing the gap G between the end face 6a and the substrate-holding surface 5a, the end face 6a and the substrate-holding surface 5a may be arranged close to each other, and the differential pressure container 6 may be provided with one or more gas communication holes.

The differential pressure container 6 is provided with the sputtering mechanism 7. The sputtering mechanism 7 of this example comprises a target 7a disposed inside the differential pressure container 6, a sputtering electrode 7b that holds the target 7a, a sputtering power source 7c that supplies electric power to the sputtering electrode 7b, and a shutter 7d that is disposed between the target 7a and the substrate holder 5 and covers or opens the target 7a. The sputtering mechanism 7 of this example is based on a DC (direct current) or RF (radio frequency) sputtering method.

The target 7a is formed of a film raw material in a flat plate-like shape and disposed inside the differential pressure container 6 so as to face the substrate-holding surface 5a of the substrate holder 5. A metal target such as Si, Zr, Al, Ti, Ta, Nb, or Hf can be used as the target 7a. In addition or alternatively, a metal oxide target such as SiO₂ may be used as the target 7a.

The differential pressure container 6 is provided with the gas instruction system 8 which introduces the sputtering gases into the differential pressure region B. The gas instruction system 8 comprises gas cylinders 8a and 8d that store the sputtering gases, valves 8b and 8e provided corresponding to the gas cylinders 8a and 8d, mass flow controllers 8c and 8f that adjust the flow rates of the sputtering gases, and a pipe 8g as a supply path for the sputtering gases.

The gas cylinder 8a, the valve 8b, and the mass flow controller 8c are used for supply of oxygen gas while the gas cylinder 8d, the valve 8e, and the mass flow controller 8f are used for supply of argon gas. In this example, an inert gas such as argon or helium and a reactive gas such as oxygen or nitrogen are introduced as the sputtering gases.

DC (direct current) sputtering using a metal target is effective for increasing the film formation speed in the sputtering film formation. When obtaining a dielectric film and/or an oxide film, the reaction may not necessarily progress and may be in an incomplete state because the reaction involves oxygen, nitrogen, or the like.

In this example, firm formation is performed using a metal target with a slight amount of reactive gas such as oxygen relative to the amount of inert gas such as argon gas. For example, the ratio of (reactive gas):(inert gas) is about 1:80. Accordingly, when complete oxide is supplied to the high vacuum region A in which the vacuum vapor deposition film formation is performed as described later, it is thereby possible to obtain a film that is close to complete oxide as a whole. As a result, a film can be obtained with a high film formation speed, high interfacial adhesion, low stress, and no optical absorption. The ratio of the reactive gas introduced into the differential pressure region B to the inert gas may be 0.5% to 15% and may preferably be 0.5% to 8%.

The vacuum vapor deposition mechanism 9, which may be an electron beam vapor deposition source, comprises a crucible 9a filled with a vapor deposition material and an electron gun 9b that irradiates the vapor deposition material filling the crucible 9a with an electron beam. In addition, a shutter 9c is provided above the crucible 9a in a movable manner to open and close the upper opening of the crucible 9a. SiO₂, MgF₂, Al₂O₃, ZrO₂, Ta₂O₅, TiO₂, Nb₂O₅, HfO₂, or the like can be used as the vapor deposition material. In this case, an oxide of the same metal as the metal or metal oxide which constitutes the target 7a can be used, or an oxide of a metal different from the metal or metal oxide which constitutes the target 7a can also be used.

The film-formation apparatus 1 used in this example is provided with the sputtering mechanism 7 and the vacuum vapor deposition mechanism 9 which are located inside the single vacuum chamber 2. In this film-formation apparatus 1, the configuration for satisfying both of two film-formation methods, that is, both the sputtering method and the vacuum vapor deposition method, in which the required degree of vacuum is significantly different, relies on the differential pressure container 6 which stores the target 7a of the sputtering mechanism 7.

Introduction of the sputtering gases into the differential pressure container 6 makes the pressure in the differential pressure region B of the differential pressure container 6 higher than that in the high vacuum region A inside the vacuum chamber 2. This can achieve a degree of vacuum of 10⁻¹ to 1 Pa that enables sputtering. For this operation, the flow rates of the sputtering gases and the dimension of the gap G are adjusted to control the pressure in the differential pressure region B. That is, when the gap G is set to a small width, a large amount of gases does not flow into the high vacuum region A inside the vacuum chamber 2 from the differential pressure container 6 and, therefore, the degree of vacuum in the vicinity of the vaporization source of the vacuum vapor deposition mechanism 9 can be made to a degree of vacuum of 10⁻⁶ to 10⁻¹ Pa that enables vacuum vapor deposition. With this configuration, the sputtering film formation and the vacuum vapor deposition film formation can be performed in the same vacuum chamber 2. Moreover, unlike the prior art, it is unnecessary to provide any step of adjusting the internal pressure of the vacuum chamber 2 to a pressure suitable for each of the sputtering film formation and the vacuum vapor deposition film formation during the switching between these film-formation methods.

In addition, the film-formation apparatus 1 used in this example is provided with the rotary-type substrate holder 5 which rotates while holding the substrates S. The substrates S therefore revolve inside the vacuum chamber 2 around the rotation shaft 4b during the film formation. This allows the substrates S to move between the differential pressure region B for the sputtering film formation and the high vacuum region A for the vacuum vapor deposition film formation. During this operation, the rotation speed of the substrate holder 5 is controlled by the driving unit 4a, so that the time to stay at each of the regions A and B can be adjusted to an arbitrary time. This indicates that the film formed by the sputtering method and the film formed by the vacuum vapor deposition method can be formed in the same vacuum chamber 2.

Furthermore, according to this example, the sputtering film formation is performed while allowing the substrates S to pass through the high vacuum region A, which is a higher vacuum than the pressure suitable for the sputtering method, by the rotation of the substrate holder 5, and the attachment of other particles than the film-forming particles to the substrates S can be suppressed, thus leading to the production of a high-quality film.

When the sputtering film formation and the vacuum vapor deposition film formation are concurrently performed, that is, alternately and repeatedly performed, the ratio of the film weight obtained by the sputtering and the film weight obtained by the vacuum vapor deposition and the total film formation amount (film thickness) can be set to desired values through adjusting the staying time of the substrates S at each of the differential pressure region B for the sputtering film formation and the high vacuum region A for the vacuum vapor deposition film formation, the film formation conditions in the sputtering mechanism 7 or the vacuum vapor deposition mechanism 9, etc.

In the prior art, a differential evacuation apparatus was necessary for achieving regions with different degrees of vacuum, so when such a different evacuation apparatus was used, two evacuation systems had to be provided and the piping systems became complicated. In contrast, in this example, the regions A and B with different degrees of vacuum can be achieved by the simple structure of the differential pressure container 6, and the whole apparatus is simplified and downsized.

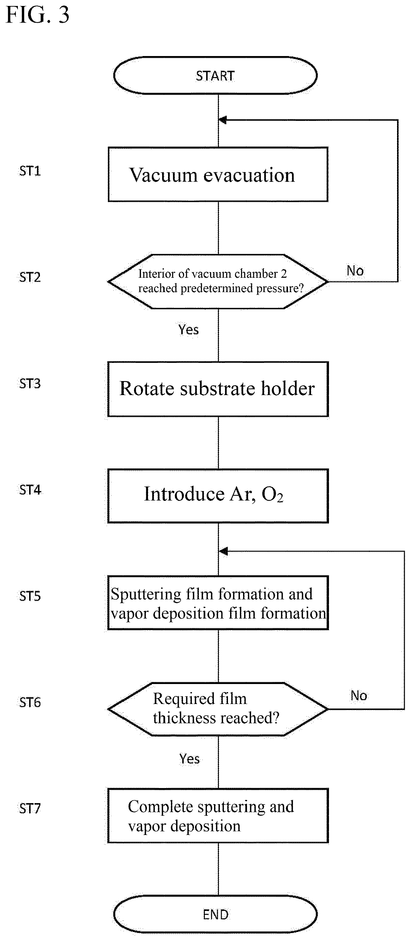

An embodiment of the film-formation method according to the present invention will then be described. FIG. 3 is a process flowchart illustrating an embodiment of the film-formation method according to the present invention. The present embodiment is an example of the film-formation method in which a step of forming an SiO₂ film by the sputtering method using the sputtering mechanism 7 and a step of forming an SiO₂ film by the vacuum vapor deposition method using the vacuum vapor deposition mechanism 9 are alternately repeated for one surface of each glass substrate S. In the film-formation method of the present invention, it is not always necessary to alternately repeat one by one the sputtering film formation and the vapor deposition film formation, and one of them may be repeated a plurality of times and then the other may be performed.

As a preliminary preparation, the substrates S are set on the substrate holder 5, which is attached to the vacuum chamber 2. After a Si target is set as the target 7a and the crucible 9a is filled with SiO₂ as the vapor deposition material, the process of FIG. 3 is started.

In step ST1, the vacuum chamber 2 is closed in a sealing manner, and the interior of the vacuum chamber 2 is evacuated (depressurized) using the evacuation apparatus 3. In step ST2, a determination is made as to whether the interior of the vacuum chamber 2 has reached a predetermined pressure, for example 7×10⁻⁴ Pa, using a pressure gauge 10 provided so as to face the high vacuum region A of the vacuum chamber 2. When the interior of the vacuum chamber 2 has not reached the predetermined pressure, for example 7×10⁻⁴ Pa, the process returns to step ST1 and vacuum evacuation is repeated until the pressure reaches 7×10⁻⁴ Pa.

When the interior of the vacuum chamber 2 reaches the predetermined pressure, it is assumed that the pressure has been reduced to a degree of vacuum suitable for vacuum vapor deposition by the vacuum vapor deposition mechanism 9, and the process proceeds to step ST3, in which the rotation of the substrate holder 5 is started. In the present embodiment, the rotation of the substrate holder 5 in step ST3 is started before the introduction of gases in step ST4, but the rotation of the substrates S may be started during the introduction of the gases or after the introduction of the gases. However, the rotation of the substrate holder 5 may affect the flow rate of the gases leaking from the gap G between the substrate holder 5 and the differential pressure container 6 to the outside of the differential pressure container 6. It is therefore preferred to start the rotation of the substrate holder 5 before the introduction of the gases or during the introduction of the gases.

In Step ST4, the valves 8b and 8e are opened to introduce the oxygen and argon gases, respectively, from the gas cylinders 8a and 8d into the differential pressure region B inside the differential pressure chamber 6. When the oxygen and argon gases are introduced into the differential pressure region B, the interior of the differential pressure region B, which has been depressurized to about 7×10⁻⁴ Pa until then by the evacuation apparatus 3, becomes a state in which the oxygen and argon gases are introduced locally therein and only a slight amount of these gases leaks at a constant flow rate to the outside of the differential pressure container 6 through the gap G.

When the introduction amount of the gases to the differential pressure region B and the leakage amount of the gases from the differential pressure region B through the gap G come to a certain balance, the pressure in the differential pressure region B is a desired pressure, which is, in the present embodiment, 10⁻¹ to 1 Pa suitable for the sputtering film formation. The pressure in the differential pressure region B may be detected by providing a pressure gauge inside the differential pressure container 6, but it has been confirmed by experiments that plasma is generated when the pressure reaches 10⁻¹ to 1 Pa. In the present embodiment, therefore, when plasma is generated inside the differential pressure container 6, a determination is made that the pressure has reached a predetermined pressure of 10⁻¹ to 1 Pa. If plasma is not generated in step ST4 even after waiting for a while, it is expected that the pressure in the differential pressure container 6 does not rise sufficiently due to a slower introduction speed of the oxygen and argon gases than the leakage speed of the gases from the gap G. In response to this, the mass flow controllers 8c and 8f are adjusted to increase the flow rates of the oxygen and argon gases.

In step ST5, the shutter 7d, which has covered the target 7a until then, is opened to perform the sputtering film formation, and the shutter 9c, which has closed the crucible 9a until then, is opened to perform the vacuum vapor deposition film formation by irradiating the crucible 9a with the electron beam from the electron gun 9b.

In step ST6, a noncontact-type film thickness sensor 11 is used to determine whether the film thickness of the thin films formed on the substrates S has reached a predetermined required film thickness. If the film thickness of the thin films formed on the substrates S has not reached the predetermined required film thickness, the step ST5 is repeated until the required film thickness is reached.

When the film thickness of the thin films formed on the substrates S has reached the predetermined required film thickness, the process is followed by step ST7, in which the sputtering film formation is completed by covering the target 7a with the shutter 7d and closing the valves 8b and 8e and the vacuum vapor film formation is also completed by turning off the electron gun 9b and closing the shutter 9c. Thereafter, the internal pressure of the vacuum chamber 2 is returned to the atmospheric pressure, and the substrate holder 5 is taken out from the vacuum chamber 2.

As described above, the film-formation method of the present embodiment includes repeating, for the surfaces of the substrates S, a step of film formation from a vapor deposition material by the vacuum vapor deposition method and a step of film formation by sputtering of a target constituent substance, thereby forming a film with a lower refractive index than that of a film-forming material. The refractive index of a film-forming material refers to the refractive index of a material itself of the film which is formed by each of the vapor deposition step and the sputtering step. For example, when the thin film to be formed is an SiO₂ film, the refractive index of a film-forming material refers to a refractive index (1.457 for light of a wavelength of 632.8 nm) that is inherently possessed by the material of SiO₂ before processing.

When the film-forming material is SiO₂, the refractive index of the obtained film is preferably smaller than the refractive index of SiO₂ itself of 1.457, more preferably 1.41 or less, and further preferably 1.35 or less. When the film-forming material is MgF₂, the refractive index of the obtained film is preferably smaller than the refractive index of MgF₂ itself of 1.38. When the obtained film is applied to uses requiring mechanical strength, such as the use as a surface layer of a substrate, the pencil hardness is preferably B or higher.

In order to obtain such a film with a low refractive index and high strength, the film weight obtained by the sputtering is preferably smaller than the film weight obtained by the vacuum vapor deposition method. For example, the ratio of the film weight obtained by the sputtering to the total film weight obtained is 0.2% to 1.4%.

In the present embodiment, SiO₂, MgF₂, Al₂O₃, ZrO₂, Ta₂O₅, TiO₂, Nb₂O₅, or HfO₂ is preferably used as the vapor deposition material, and Si, Al, Zr, Ta, Ti, Nb, Hf, or a metal oxide thereof is preferably used as the target constituent substance. In this case, the refractive index of the film to be formed may be controlled by using the vapor deposition material and the target constituent substance made of a material different from the vapor deposition material.

From another viewpoint of the present embodiment, a film with a lower refractive index than that of a film-forming material can also be formed through repeating, for the surface of a substrate, a step of film formation from a vapor deposition material by a vacuum vapor deposition method in an atmosphere of a predetermined degree of vacuum and a step of exposure to a plasma atmosphere of a lower degree of vacuum than the predetermined degree of vacuum.

According to the film-formation method of the present embodiment, light reflection on the substrate surface can be suppressed and it is therefore possible to prevent the occurrence of flare and ghosting, glaring of external light, etc. Moreover, a thin film having a desired refractive index can be obtained for or from a film-forming material having a higher refractive index than that of glass: therefore, a desired refractive index can be freely selected without being bound by the refractive indices of existing materials and it is thus possible to increase the degree of freedom in designing optical thin films.

### [Examples]

### «Examples and Comparative Examples»

The film-formation apparatus of FIGS. 1 and 2 was used and the method illustrated in FIG. 3 was employed to form SiO₂ films with a target film thickness of 500 nm on one surfaces of glass substrates S (N-BK7 available from SCHOTT AG, plate thickness 1.0 mm, 40×40 mm, refractive index n_{d}: 1.5168). The spectral transmittance of each formed film was measured using a spectrophotometer (V-570 available from JASCO Corporation), and the refractive index of the film was calculated from the transmittance. For the same film, the crosshatch test (in accordance with JIS B7080-4, Optics and photonics-Optical coatings-Part 4: Specific test methods, 7. Crosshatch test (Condition method 03)) and the pencil hardness test (in accordance with JIS K5600, Testing methods for paints, 4.4 Scratch hardness (Pencil hardness method)) were performed. The film formation conditions in the film-formation apparatus at that time are as follows.

The ratio of the volume of the vacuum chamber 2 and the volume of the differential pressure container 6 was 1:0.02, the vertical distance H between the crucible 9a of the vacuum vapor deposition mechanism 9 and the substrates S illustrated in FIG. 1 was 35 to 50 cm, the target degree of vacuum in the high vacuum region A was 7×10⁻⁴ Pa, and the target degree of vacuum in the differential pressure region B was 10⁻¹ to 1 Pa. For the sputtering film formation, RF sputtering was performed using an RF power supply as the sputtering power source 7c. A Si target was used as the target 7a, and oxygen (5, 20, or 35 sccm) and argon (45, 60, or 75 sccm) were introduced as the sputtering gases so that the total gas flow rate would be 80 sccm. The RF power of the sputtering power source 7c was 100, 200, or 300 W.

For the vacuum vapor deposition film formation, SiO₂ was used as the vapor deposition material, and the current amount of the electron gun 9b was 70 or 120 mA. A reactive gas such as oxygen was not introduced into the high vacuum region A. The substrates S were heated to 200°C. The sputtered film weight ratio (%) in the following Table 1 was converted from (sputtering rate/vapor deposition rate)×100. Comparative Example 1 represents an example in which the same film-formation apparatus 1 was used to perform film formation only by vacuum vapor deposition (the RF power was 0 and the sputtering gas flow rate was 0), Comparative Example 2 represents an example in which the same film-formation apparatus 1 was used to perform film formation only by sputtering (the vapor deposition electron gun current was 0), and Comparative Example 3 represents an example in which the same film-formation apparatus 1 was used, but film formation by sputtering was not performed with an RF power of 0 and a sputtering gas total flow rate of 80 sccm only for flowing the sputtering gases.

**[Table 1]**

| | Substrate holder rotation speed (rpm) | Substrate temperature (°C) | RF power (W) | Sputtering gas total flow rate (sccm) | Vapor deposition electron gun current (mA) | Sputtering film weight ratio (%) | Refractive index | Crosshatch test (remaining number/number of tests) | Pencil hardness test |
|---|---|---|---|---|---|---|---|---|---|
| Example 1 | 10 | 200 | 100 | 80 | 70 | 0.7 | 1.31 | 25/25 | B |
| Example 2 | 10 | 200 | 200 | 80 | 70 | 1.4 | 1.33 | 25/25 | H |
| Example 3 | 10 | 200 | 300 | 80 | 70 | 2.1 | 1.33 | 25/25 | H |
| Example 4 | 10 | 200 | 100 | 80 | 120 | 0.2 | 1.35 | 25/25 | H |
| Example 5 | 10 | 200 | 200 | 80 | 120 | 0.4 | 1.37 | 25/25 | H |
| Example 6 | 10 | 200 | 300 | 80 | 120 | 0.6 | 1.39 | 25/25 | 2H |
| Example 7 | 5 | 200 | 200 | 80 | 120 | 0.4 | 1.41 | 25/25 | 2H |
| Example 8 | 20 | 200 | 200 | 80 | 120 | 0.4 | 1.37 | 25/25 | H |
| Comparative Example 1 | 10 | 200 | 0 | 0 | 120 | 0 | 1.46 | 25/25 | 5H |
| Comparative Example 2 | 10 | 200 | 200 | 80 | 0 | 100 | 1.47 | 25/25 | 9H or higher |
| Comparative Example 3 | 10 | 200 | 0 | 80 | 120 | 0 | 1.32 | 0/25 | 6B or lower |

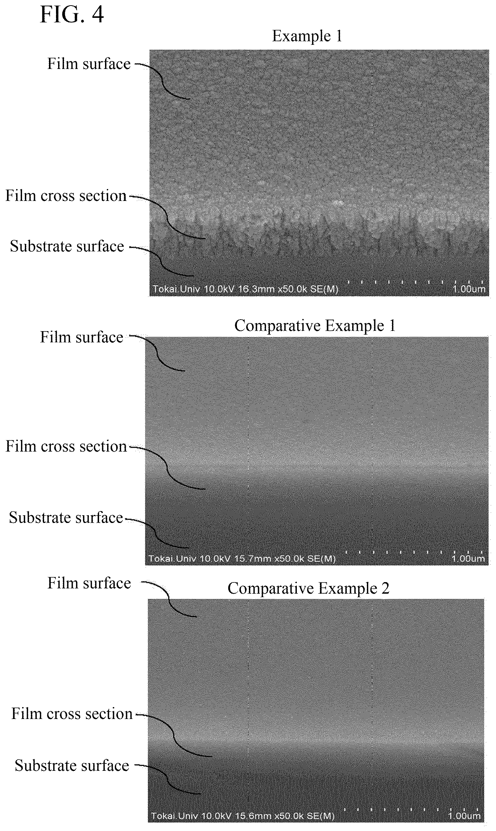

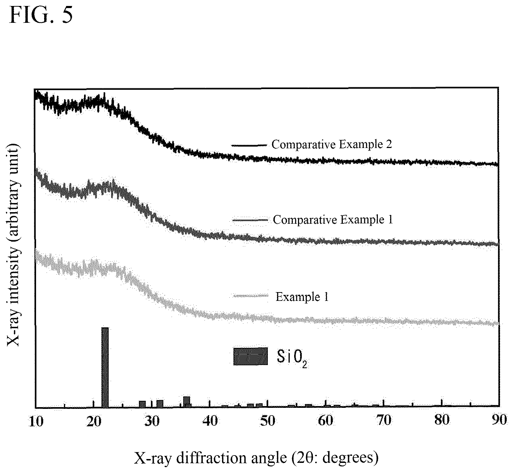

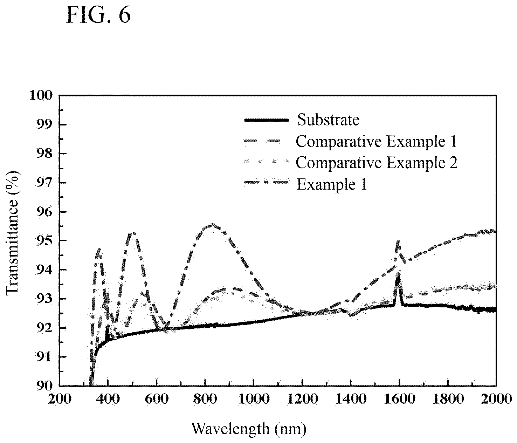

FIG. 4 presents results when cutting the films obtained in Example 1, Comparative Example 1, and Comparative Example 2 and observing them using a scanning electron microscope. FIG. 5 presents results when analyzing the crystal structures of the films obtained in Example 1, Comparative Example 1, and Comparative Example 2 by an X-ray diffraction method. FIG. 6 presents results when measuring the transmittance of the films and substrates S of Example 1, Comparative Example 1, Comparative Example 2 using a spectrophotometer (V-570 available from JASCO Corporation).

### «Discussion»

(1) As in Comparative Examples 1 and 2, when an SiO₂ film is formed on the surface of the glass substrate only by the vacuum vapor deposition method or only by the sputtering method, a film is formed with a refractive index that is substantially equal to the refractive index 1.457 of the film-forming material SiO₂. In contrast, as in Examples 1 to 8, when the vacuum vapor deposition method and the sputtering method are repeatedly performed, a film is formed with a refractive index of 1.31 to 1.41 lower than the refractive index 1.457 of the film-forming material SiO₂. Moreover, the films of low refractive indices in Examples 1 to 8 have significantly higher mechanical strength as confirmed by the crosshatch test, the pencil hardness test, and the like, when compared with the film of low refractive index (1.32) in Comparative Example 3.
(2) Although the detailed mechanism of why both the low refractive index and the high strength are obtained is not clear, it is inferred that the following reasons affect the fact that thin films can be obtained with low refractive indices and high strength as in Examples 1 to 8. As in Comparative Example 3, when the sputtering film formation is set to zero and only the vacuum vapor deposition film formation is performed, a film having a low refractive index of about 1.32 can be obtained, but as can be seen in the results of the cross hatch test and the pencil hardness test, the strength is insufficient. This is because the degree of vacuum in the high vacuum region A is deteriorated due to the gases leaking from the differential pressure container 6 (differential pressure region B), so that the film has poor denseness and becomes porous to reduce the refractive index. This is consistent with the SEM observation. Then, this film, which is becoming porous due to the vacuum vapor deposition, is given some physical energy such as due to collision of the sputtered particles during the sputtering film formation and the porous film is thereby compressed or condensed, which enhances the strength of the intrinsically low-strength porous film. This is consistent with the fact that thin films with low refractive indices and high strength can be obtained as in Examples 1 to 8 even when the film weight ratio obtained by the sputtering film formation is about 0.2% to 2.1%. It is also consistent with the results of X-ray diffraction analysis illustrated in FIG. 5 in which a strong peak due to diffraction at crystal faces was not observed, so the obtained thin film was amorphous, and the enhanced strength of the film is not due to crystallization.
(3) Even when the film weight ratio obtained by the sputtering film formation is about 0.2% to 2.1%, thin films with low refractive indices and high strength can be obtained as in Examples 1 to 8. Thus, it is also considered that the plasma energy of the sputtering step affects the enhanced strength of the thin films.
(4) As illustrated in FIG. 6, the thin film obtained in Example 1 exhibits a transmittance of 91% or more over a wavelength range of 300 to 2000 nm including visible light of 360 to 830 nm.
(5) Comparing the refractive indices of Examples 7, 5, and 8 in which the rotation speed of the substrate holder 5 is set to different values of 5, 10, and 20 rpm, respectively, they were 1.41, 1.37, and 1.37. These results show that the influence of the rotation speed on the refractive index is not large.
(6) Comparing the refractive indices of each of pairs of Examples 1 and 4, Examples 2 and 5, and Examples 3 and 6 in which the vapor deposition electron gun current was set to 70 mA or 120 mA and the RF power was set to the same value, films with low refractive indices were obtained when the vapor deposition electron gun current was set to a relatively low value of 70 mA.

### [Description of Reference Numerals]

- A: High vacuum region
- B: Differential pressure region
- G: Gap
- S: Substrate
- 1: Film-formation apparatus
- 2: Vacuum chamber
- 3: Evacuation apparatus
- 4a: Driving unit
- 4b: Rotation shaft
- 5: Substrate holder
- 5a: Substrate-holding surface
- 5b: Sputtering part
- 6: Differential pressure container
- 6a: End surface
- 7: Sputtering mechanism
- 7a: Target
- 7b: Sputtering electrode
- 7c: Sputtering power source
- 7d: Shutter
- 8: Gas instruction system
- 8a, 8d: Gas cylinder
- 8b, 8e: Valve
- 8c, 8f: Mass flow controller
- 8g: Pipe
- 9: Vacuum vapor deposition mechanism
- 9a: Crucible
- 9b: Electron gun
- 9c: Shutter
- 10: Pressure gauge
- 11: Film thickness sensor

## Claims

1. A film-formation method comprising:
repeating, for a surface of a substrate, a step of film formation from a vapor deposition material by a vacuum vapor deposition method and a step of film formation by sputtering of a target constituent substance, thereby forming a film with a lower refractive index than that of a film-forming material.

2. The film-formation method according to claim 1, wherein the film-forming material is SiO₂ and the film is formed with a refractive index of less than 1.46.

3. The film-formation method according to claim 1, wherein the film-forming material is MgF₂ and the film is formed with a refractive index of less than 1.38.

4. The film-formation method according to claim 2, wherein the film is formed with a refractive index of 1.41 or less.

5. The film-formation method according to any one of claims 1 to 4, wherein the film is formed with a pencil hardness of B or higher.

6. The film-formation method according to any one of claims 1 to 5, wherein a film weight obtained by the sputtering is smaller than a film weight obtained by the vapor deposition method.

7. The film-formation method according to claim 6, wherein a ratio of the film weight obtained by the sputtering to a total film weight obtained is 0.2% to 1.4%.

8. The film-formation method according to any one of claims 1 to 7, wherein the vapor deposition material is SiO₂, MgF₂, Al₂O₃, ZrO₂, Ta₂O₅, TiO₂, Nb₂O₅, or HfO₂, the target constituent substance is Si, Al, Zr, Ta, Ti, Nb, Hf, or a metal oxide thereof, and the substrate is a glass substrate or a plastic substrate.

9. The film-formation method according to any one of claims 1 to 8, wherein the refractive index of the film to be formed is controlled by using the vapor deposition material and the target constituent substance made of a material different from the vapor deposition material.

10. The film-formation method according to any one of claims 1 to 9, wherein the film-formation method includes using a film-formation apparatus to form a thin film on the surface of the substrate,
wherein the film-formation apparatus comprises:
a vacuum chamber;
a substrate holder provided rotatably inside the vacuum chamber and configured to hold the substrate on a substrate-holding surface;
a differential pressure container provided to face a part of the substrate-holding surface inside the vacuum chamber and separated physically from another region inside the vacuum chamber in a state of communicating with the other region through a small gap;
a sputtering mechanism provided inside the differential pressure container;
a gas introduction system configured to introduce a sputtering gas into the differential pressure container; and
a vacuum vapor deposition mechanism provided inside the vacuum chamber to face the substrate-holding surface,
wherein the film-formation method includes repeating a sputtering step and a vapor deposition step inside the vacuum chamber to form the thin film on the surface of the substrate,
wherein the sputtering step includes:
reducing a pressure in the vacuum chamber to adjust the pressure to a first pressure;
adjusting an inner pressure of the differential pressure container to a second pressure lower than the first pressure through: introducing the sputtering gas into the differential pressure container while rotating the substrate holder holding the substrate; and adjusting a flow rate of the sputtering gas and a clearance of the gap; and
thereafter generating plasma inside the differential pressure container to perform film formation by sputtering on the surface of the substrate at the part of the substrate-holding surface in a state in which a gas in the differential pressure container leaks through the gap with a flow rate adjusted by the flow rate of the sputtering gas and the clearance of the gap, and
the vapor deposition step includes performing film formation, while rotating the substrate holder, on the surface of the substrate by the vacuum vapor deposition method at another part of the substrate-holding surface which the differential pressure container does not face.

11. A film-formation method comprising:
repeating, for a surface of a substrate, a step of film formation from a vapor deposition material by a vacuum vapor deposition method in an atmosphere of a predetermined degree of vacuum and a step of exposure to a plasma atmosphere of a lower degree of vacuum than the predetermined degree of vacuum, thereby forming a film with a lower refractive index than that of the vapor deposition material or of a target constituent substance.
